# EUROPÄISCHE PATENTSCHRIFT

(11) **EP 1 526 623 B1**
(45) Veröffentlichungstag und Bekanntmachung des Hinweises auf die Patenterteilung: **04.07.2007**
(21) Anmeldenummer: 03103955.5
(22) Anmeldetag: 24.10.2003
(51) Int. Cl.: H02H 9/00

(54) **Elektrische Schaltung zur Einschaltstrombegrenzung**
Inrush current limiting circuit
Circuit de limitation d'un courant d'appel

(43) Veröffentlichungstag der Anmeldung: 27.04.2005
(73) Patentinhaber: Agfa-Gevaert HealthCare GmbH, 51373 Leverkusen (DE)
(72) Erfinder: Benzinger, Rupert, 84564, Finsing (DE); Serro, Hannes, 85540, Haar (DE)

(56) Entgegenhaltungen:
- DE-A- 10 032 197
- US-A- 5 283 707
- US-A- 5 374 887
- US-A- 5 635 804
- US-B1- 6 320 283

## Beschreibung

Die Erfindung betrifft eine elektrische Schaltung zur Begrenzung des Einschaltstroms durch einen Verbraucher während eines Einschaltvorgangs gemäß dem Oberbegriff von Anspruch 1.

Aus der DE 41 21 055 A1 ist eine Schaltungsanordnung zur Einschaltstrombegrenzung von Glühbirnen bekannt, bei welcher ein Vorwiderstand in Reihe mit einer Glühbirne geschaltet wird. Parallel zum Vorwiderstand ist ein Schalttransistor vorgesehen, der über einen Zündtransistor angesteuert wird. Der Zündtransistor wird eingangsseitig mit dem an der Glühbirne entstehenden Spannungsabfall gespeist. Nach Einschalten der Versorgungsspannung nimmt der Spannungsabfall an der Glühbirne allmählich zu, da sich der Widerstand der Glühbirne mit ansteigender Betriebstemperatur erhöht. Wenn ein bestimmter Spannungsabfall an der Glühbirne erreicht ist, schaltet der Zündtransistor durch und steuert den Schalttransistor derart an, dass dieser ebenfalls durchschaltet und dabei den Vorwiderstand überbrückt, wodurch der Strom durch die Glühbirne nicht mehr durch den Vorwiderstand begrenzt wird.

Bei dieser Schaltungsanordnung nach dem Stand der Technik ist die Wirkung der Strombegrenzung stark von der Art des Verbrauchers und der Höhe der Versorgungsspannung abhängig, so dass die Schaltungsanordnung für jeden Verbraucher bzw. jede Versorgungsspannung neu dimensioniert werden muss. Darüber hinaus können zum Zeitpunkt des Durchschaltens des Schalt- bzw. Zündtransistors kurzzeitig hohe Umschaltstromspitzen auftreten, die sowohl die Versorgungsspannungsquelle belasten als auch zu einer Beschädigung des Verbrauchers führen können. Außerdem tritt bei dieser Schaltungsanordnung auch nach dem Durchschalten des Schalttransistors ein endlicher Spannungsabfall zwischen Kollektor und Emitter des Schalttransistors bzw. am Vorwiderstand auf, welcher zur Produktion von Verlustwärme führt.

Das Dokument FR 1 448 312, das als nächstliegender Stand der Technik angesehen wird, zeigt eine Schaltungsanordnung, wobei das mit dem Verbraucher in Reihe geschaltete strombegrenzende elektrische Bauelement als aktives Bauelement ausgebildet ist, welches einen Innenwiderstand aufweist, und wobei ein Zeitglied vorgesehen ist, welches das Bauelement in der Weise ansteuert, dass der Innenwiderstand des Bauelements während des Einschaltvorgangs abnimmt.

Es ist Aufgabe der Erfindung, eine elektrische Schaltung der eingangs genannten Art anzugeben, deren strombegrenzende Wirkung unabhängig ist vom Verbraucher und der Höhe der Versorgungsspannung, bei welcher Umschaltstromspitzen vermieden und die Erzeugung von Verlustwärme minimiert wird.

Diese Aufgabe wird gemäß Anspruch 1 dadurch gelöst, dass ein erster Anschluss des Kondensators mit dem Eingang des Transistors und ein zweiter Anschluss des Kondensators mit einem ersten Anschluss des ersten ohmschen Widerstands und mit einem ersten Anschluss eines zweiten ohmschen Widerstands gekoppelt ist.

Die Erfindung basiert auf dem Gedanken, als strombegrenzendes Bauelement anstelle eines ohmschen Vorwiderstands ein aktives Bauelement, wie z. B. einen Transistor, einzusetzen, das von einem Zeitglied angesteuert wird. Der Einschaltstrom durch den Verbraucher wird dabei durch den Spannungsabfall am Innenwiderstand des aktiven Bauelements begrenzt. Das vom Verbraucher unabhängige Zeitglied steuert das Bauelement dabei so an, dass sein Innenwiderstand während des Einschaltvorgangs abnimmt, bis schließlich am Ende des Einschaltvorgangs keine Strombegrenzung mehr erfolgt.

Durch das Zeitglied zur Ansteuerung des aktiven Bauelements wird eine vom Verbraucher und der Höhe der Versorgungsspannung unabhängige Strombegrenzung erreicht. Darüber hinaus kann dabei das aktive Bauelement derart angesteuert werden, dass dessen Innenwiderstand kontinuierlich abnimmt, wodurch Umschaltstromspitzen vermieden werden können. Außerdem tritt bei der erfindungsgemäßen Schaltung nach Beendigung des Einschaltvorgangs lediglich ein vernachlässigbar kleiner Spannungsabfall am aktiven Bauelement, insbesondere zwischen Kollektor und Emitter eines Transistors, auf, so dass Wärmeverluste stark vermindert werden.

In einer bevorzugten Ausgestaltung ist vorgesehen, dass das Zeitglied derart ausgestaltet ist, dass der Innenwiderstand des Bauelements während des Einschaltvorgangs kontinuierlich, insbesondere exponentiell, abnimmt. Hierdurch werden etwaige Umschaltstromspitzen mit hoher Zuverlässigkeit vermieden, und es wird gleichzeitig ein den Verbraucher schonendes, sanftes Einschalten erreicht.

Vorzugsweise weist das Zeitglied ein vom Verbraucher unabhängiges zeitliches Verhalten auf. Hierdurch wird gewährleistet, dass die Zeitdauer des Einschaltvorgangs sowie dessen zeitlicher Verlauf nicht von Parametern des Verbrauchers, wie z. B. den Verbraucherwiderstand und/oder dessen Temperaturverhalten, beeinflusst werden.

In einer bevorzugten Ausgestaltung der Erfindung ist vorgesehen, dass das Zeitglied einen Kondensator und einen ersten ohmschen Widerstand umfasst, über welchen der Kondensator geladen werden kann. Durch ein solches sogenanntes RC-Glied kann das Zeitglied auf einfache und zuverlässige Weise realisiert werden.

Vorzugsweise kann hierbei der Kondensator des Zeitglieds durch eine zumindest während des Einschaltvorgangs am Zeitglied anliegende Einschaltspannung, welche von der Versorgungsspannung des Verbrauchers unabhängig ist, geladen werden. Hierdurch wird die Unabhängigkeit der Strombegrenzung von Eigenschaften des Verbrauchers und der Versorgungsspannung in besonders zuverlässiger Weise gewährleistet.

Als aktives Bauelement wird vorzugsweise ein Transistor, insbesondere ein Feldeffekt-Transistor verwendet. Der Feldeffekt-Transistor ist vorzugsweise als MOS-Feldeffekt-Transistor (MOSFET) ausgestaltet. Hierdurch wird eine Begrenzung des Einschaltstroms mit besonders wenig Verlustwärme ermöglicht.

Vorzugsweise ist zumindest ein Teil der erfindungsgemäßen elektrischen Schaltung als integrierter Schaltkreis ausgeführt. Hierdurch wird neben einer größeren Kompaktheit der Schaltung eine einfachere Austauschbarkeit im Falle eines Defekts oder zu Wartungszwecken ermöglicht.

Vorzugsweise weist der integrierte Schaltkreis zwei Anschlüsse auf, an welchen der Kondensator des Zeitglieds angeschlossen werden kann. Durch die Wahl der Kapazität des als diskretes Bauelement gestalteten Kondensators kann auf einfache Weise das Zeitverhalten des Zeitglieds und damit der Einschaltstrombegrenzung, insbesondere die Dauer des Einschaltvorgangs, gewählt werden, ohne dass hierfür der integrierte Schaltkreis ausgewechselt werden muss.

In analoger Weise kann der integrierte Schaltkreis zwei Anschlüsse aufweisen, an welchen der erste ohmsche Widerstand des Zeitglieds angeschlossen werden kann. Auch hierdurch kann auf einfache Weise das Zeitverhalten des Zeitglieds gewählt werden. Beispielsweise kann der ohmsche Widerstand als regelbarer Widerstand, z.B. als Drehpotentiometer, ausgebildet sein, was eine Einstellung des Zeitverhaltens besonders einfach macht.

Vorzugsweise ist der integrierte Schaltkreis als oberflächenmontierbares Bauelement (surface-mounted device, SMD) ausgestaltet, was eine besonders einfache Montierbarkeit der elektrischen Schaltung, insbesondere in Verbindung mit dem diskret aufgebauten Kondensator und/oder ersten ohmschen Widerstand, ermöglicht.

Nachfolgend wird die Erfindung sowie weitere bevorzugte Ausführungsformen der Erfindung anhand von Figuren näher erläutert.

Es zeigen:
- Fig. 1: Die erfindungsgemäße elektrische Schaltung in einer ersten Ausführungsform;
- Fig. 2: den zeitlichen Verlauf der Einschaltspannung während des Einschaltvorgangs;
- Fig. 3: den zeitlichen Verlauf der am Steueranschluss des Transistors liegenden Spannung;
- Fig. 4: den zeitlichen Verlauf des Innenwiderstands des Transistors; und
- Fig. 5: eine zweite Ausführungsform der erfindungsgemäßen elektrischen Schaltung.

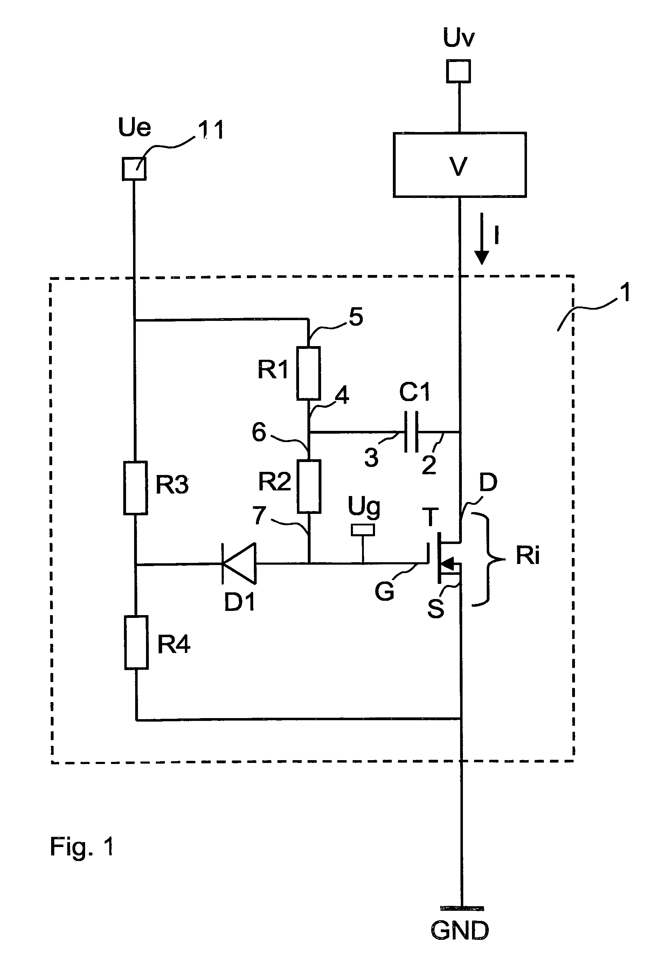

Figur 1 zeigt die erfindungsgemäße elektrische Schaltung 1 in einer ersten Ausführungsform. In Reihe mit einem Gleichstrom (DC)-Verbraucher V ist ein Transistor T, in diesem Beispiel ein MOS-Feldeffekt-Transistor (MOSFET), geschaltet, der von einem Zeitglied angesteuert wird, welches einen ersten ohmschen Widerstand R1 und einen Kondensator C1 umfasst.

Ein erster Anschluss 2 des Kondensators C1 ist hierbei mit einem Eingang D des Transistors T gekoppelt. Ein zweiter Anschluss 3 des Kondensators C1 ist mit einem ersten Anschluss 4 des ersten ohmschen Widerstands R1 gekoppelt. Der zweite Anschluss 3 des Kondensators C1 ist außerdem mit einem ersten Anschluss 6 eines zweiten ohmschen Widerstands R2 gekoppelt, dessen zweiter Anschluss 7 mit einem Steueranschluss G des Transistors T verbunden ist.

Der Steueranschluss G des Transistors T ist über eine Diode D1 und einen dritten ohmschen Widerstand R3 mit einem zweiten Anschluss 5 des ersten ohmschen Widerstands R1 gekoppelt. Darüber hinaus ist der Steueranschluss G über die Diode D1 und einen vierten ohmschen Widerstand R4 mit einem Ausgang S des Transistors T verbunden. Der Ausgang S des Transistors T liegt außerdem auf Masse GND, und der Eingang D des Transistors T ist mit dem Verbraucher V verbunden. Letzterer ist an der Versorgungsspannung Uv angeschlossen.

Am zweiten Anschluss 5 des ersten ohmschen Widerstands R1 ist ein erster Anschluss 11 vorgesehen, an welchem zumindest während des Einschaltvorgangs eine Einschaltspannung Ue angelegt werden kann.

Die in Figur 1 gezeigte elektrische Schaltung 1 kann vollständig oder teilweise als integrierter Schaltkreis ausgeführt sein, d.h. alle Komponenten oder nur ein Teil der Komponenten der elektrischen Schaltung 1 können auf einem Chip integriert sein.

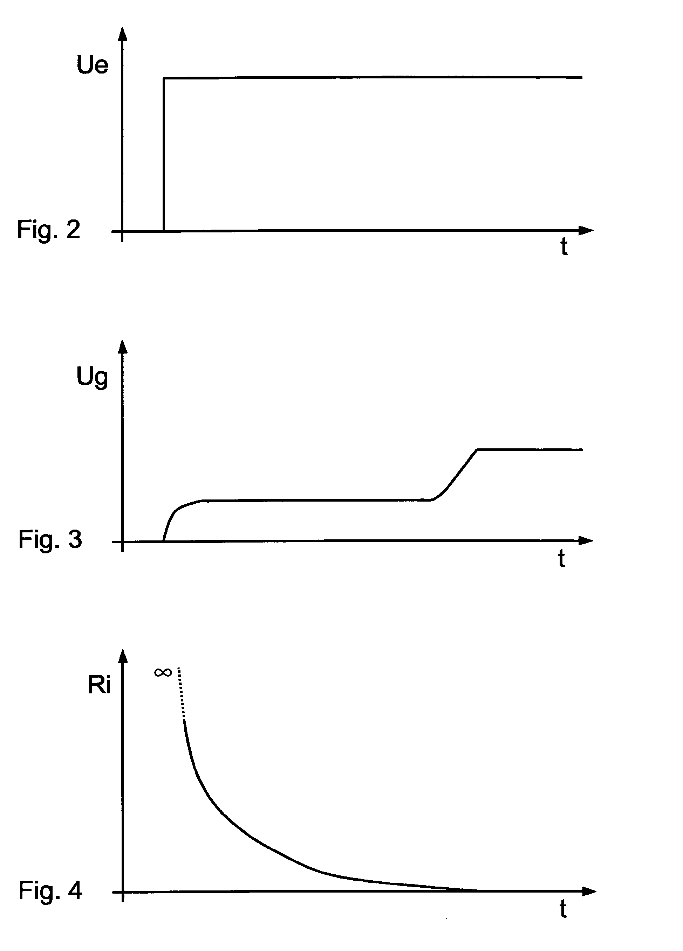

Nachfolgend wird die Funktionsweise der in Figur 1 dargestellten elektrischen Schaltung 1 unter Bezugnahme auf die Figuren 2 bis 4 näher erläutert.

Wird am ersten Anschluss 11 der elektrischen Schaltung 1 eine Einschaltspannung Ue angelegt (siehe Fig. 2), so stellt sich am Steueranschluss G des Transistors T eine Spannung Ug ein, deren zeitlicher Verlauf in Figur 3 dargestellt ist. Demnach liegt am Steueranschluss G des Transistors T schon kurz nach Beginn des Einschaltvorgangs eine Spannung Ug an, die den anfangs sehr hochohmigen Innenwiderstand Ri des Transistors T etwas vermindert. Durch den zweiten ohmschen Widerstand R2 wird dabei ein kurzzeitiges, vollständiges Durchschalten des Transistors T verhindert, bevor der Aufladevorgang des Kondensators C1 beginnt.

Durch den dritten und vierten ohmschen Widerstand R3 und R4 wird die Einschaltspannung Ue derart geteilt, dass die am Steueranschluss G des Transistors T anliegende Spannung Ug nicht zu hohe Werte erreichen kann. Hierdurch wird der Transistor T vor zu hohen Steuerspannungen Ug geschützt.

Durch den Aufladevorgang des Kondensators C1 über den ersten ohmschen Widerstand R1 sowie den allmählich niederohmig werdenden Innenwiderstand Ri des Transistors T ergibt sich am Steueranschluss G des Transistors T im Weiteren der in Figur 3 dargestellte Verlauf der Spannung Ug.

Infolge dieses Spannungsverlaufs wird der Transistor T derart gesteuert, dass sein Innenwiderstand Ri von einem anfangs hochohmigen Zustand exponentiell fallend in einen niederohmigen Zustand gebracht wird. Dieser zeitliche Verlauf des Innenwiderstands Ri des Transistors T ist in Figur 4 dargestellt. Der hochohmige Zustand zu Beginn des Einschaltvorgangs ist in der Figur durch einen nach Unendlich (∞) strebenden, gepunkteten Abschnitt des Widerstandsverlaufs angedeutet.

Durch den exponentiell fallenden Innenwiderstand Ri des Transistors T wird der Einschaltstrom I durch den Verbraucher V ebenfalls zeitlich exponentiell fallend begrenzt. Nach einer vorgebbaren Dauer des Einschaltvorgangs - typischerweise zwischen etwa 100 und 1000 Millisekunden - wird hierbei der Innenwiderstand Ri des Transistors T sehr niederohmig, so dass ein nur noch vernachlässigbar kleiner Spannungsabfall am Transistor T auftritt und damit nahezu die gesamte Versorgungsspannung Uv am Verbraucher V anliegt. Der Verbraucher V befindet sich nun im eingeschalteten Zustand, d.h. im Normalbetrieb.

Zum Ausschalten des Verbrauchers V wird die Einschaltspannung Ue weggenommen oder auf Massepotential GND gezogen. Dabei entlädt sich der Kondensator C1 über den zweiten, dritten und vierten ohmschen Widerstand R2, R3 bzw. R4 sowie die Diode D1 sehr schnell, so dass ein schnelles - d.h. im Bereich von einer oder wenigen Millisekunden - Sperren des Transistors T und damit Abschalten des Verbrauchers V die Folge ist. Durch den zweiten ohmschen Widerstand R2 wird gleichzeitig der Transistor T am Steueranschluss G vor etwaigen Spannungsspitzen während des Ausschaltens geschützt.

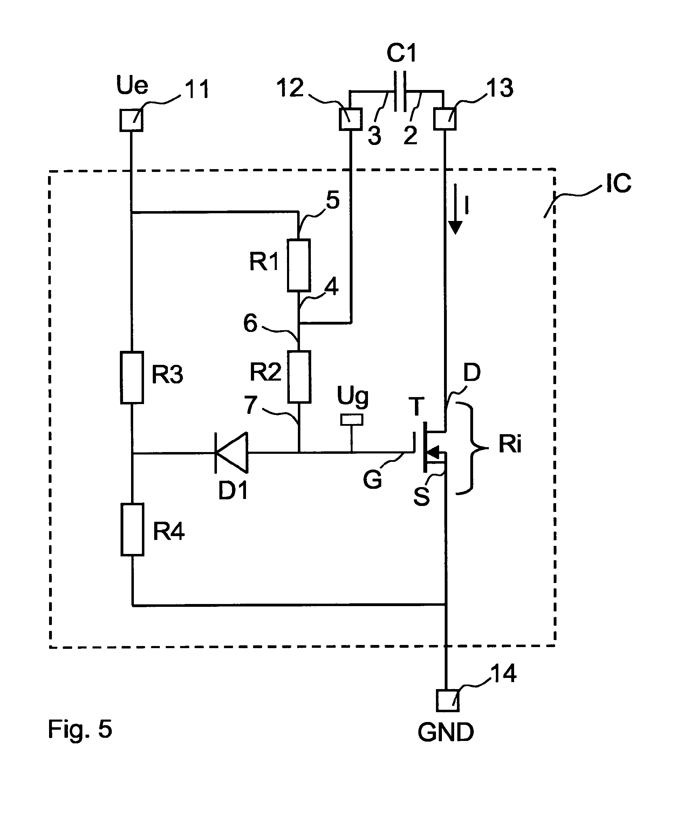

Die in Figur 5 dargestellte zweite Ausführungsform der erfindungsgemäßen elektrischen Schaltung ist teilweise als integrierter Schaltkreis IC ausgeführt, bei welchem die Komponenten der Schaltung - mit Ausnahme des Kondensators C1 - auf einem Chip integriert sind.

Neben einem ersten Anschluss 11 an welchem die Einschaltspannung Ue angelegt werden kann, weist der integrierte Schaltkreis IC einen zweiten und einen dritten Anschluss 12 bzw. 13 auf, an welchen der als diskretes Bauelement ausgeführte Kondensator C1 angeschlossen werden kann. Durch die Wahl der Kapazität des Kondensators C1 kann auf einfache Weise das zeitliche Verhalten des integrierten Einschaltstrombegrenzers eingestellt werden, ohne dass hierfür ein anders dimensionierter integrierter Schaltkreis erforderlich wäre.

Des Weiteren weist der integrierte Schaltkreis IC einen vierten Anschluss 14 auf, welcher vorzugsweise auf Masse GNG liegt, während am dritten Anschluss 13, wie bei der in Figur 1 dargestellten Ausführungsform, der Verbraucher V angeschlossen wird.

Da das zeitliche Verhalten des Zeitglieds auch durch den ersten ohmschen Widerstand R1 beeinflusst wird, kann der integrierte Schaltkreis IC auch ohne ersten ohmschen Widerstand ausgeführt sein. Der erste ohmsche Widerstand R1 des Zeitglieds wird dann - in analoger Weise - als diskretes Bauelement von außen am ersten und zweiten Anschluss 11 und 12 des integrierten Schaltkreises IC angeschlossen.

Im Übrigen gelten für das Ausführungsbeispiel der Figur 5 die Erläuterungen zu den Figuren 1 bis 4 entsprechend.

## Patentansprüche

1. Elektrische Schaltung zur Begrenzung des Einschaltstroms (I) durch einen Verbraucher (V) während eines Einschaltvorgangs, umfassend
- ein elektrisches Bauelement (T), welches mit dem Verbraucher (V) in Reihe geschaltet wird, wobei das Bauelement (T) als aktives Bauelement, welches einen Innenwiderstand (Ri) aufweist, ausgebildet ist und einen Transistor (T) mit einem Eingang (D), einem Ausgang (S) und einem Steueranschluss (G) umfasst, wobei der Eingang (D) des Transistors (T) mit dem Verbraucher (V) verbunden ist, und
- ein Zeitglied (R1, C1), welches das Bauelement (T) in der Weise ansteuert, dass der Innenwiderstand (Ri) des Bauelements (T) während des Einschaltvorgangs abnimmt, wobei das Zeitglied (R1, C1) einen Kondensator (C1) und einen ersten ohmschen Widerstand (R1) umfasst, über welchen der Kondensator (C1) geladen werden kann,
**dadurch gekennzeichnet, dass**
der Ausgang (S) des Transistors (T) auf Masse (GND) liegt, ein erster Anschluss (2) des Kondensators (C1) mit dem Eingang (D) des Transistors (T) und ein zweiter Anschluss (3) des Kondensators (C1) mit einem ersten Anschluss (4) des ersten ohmschen Widerstands (R1) und mit einem ersten Anschluss (6) eines zweiten ohmschen Widerstands (R2) gekoppelt ist und ein zweiter Anschluss (7) des zweiten ohmschen Widerstands (R2) mit dem Steueranschluss (G) des Transistors (T) gekoppelt ist und an einem zweiten Anschluss (5) des ersten ohmschen Widerstands (R1) zumindest während des Einschaltvorgangs eine Einschaltspannung (Ue) anliegt, über welche der Kondensator (C1) geladen werden kann.

2. Elektrische Schaltung nach Anspruch 1, **dadurch gekennzeichnet, dass** das Zeitglied (R1, C1) derart ausgestaltet ist, dass der Innenwiderstand (Ri) des Bauelements (T) während des Einschaltvorgangs kontinuierlich, insbesondere exponentiell, abnimmt.

3. Elektrische Schaltung nach einem der Ansprüche 1 oder 2, **dadurch gekennzeichnet, dass** das Zeitglied (R1, C1) ein vom Verbraucher (V) unabhängiges zeitliches Verhalten aufweist.

4. Elektrische Schaltung nach Anspruch 1, **dadurch gekennzeichnet, dass** der Transistor (T) als Feldeffekt-Transistor (FET), insbesondere als MOS-Feldeffekt-Transistor (MOSFET), ausgestaltet ist.

5. Elektrische Schaltung nach Anspruch 1, **dadurch gekennzeichnet, dass** der Steueranschluss (G) des Transistors (T) über eine Diode (D1) und/oder einen dritten ohmschen Widerstand (R3) mit einem zweiten Anschluss (5) des ersten ohmschen Widerstands (R1) gekoppelt ist.

6. Elektrische Schaltung nach Anspruch 1, **dadurch gekennzeichnet, dass** der Steueranschluss (G) des Transistors (T) über eine Diode (D1) und/oder einen vierten ohmschen Widerstand (R4) mit dem Ausgang (S) des Transistors (T) gekoppelt ist.

7. Elektrische Schaltung nach einem der vorangehenden Ansprüche, **dadurch gekennzeichnet, dass** zumindest ein Teil der elektrischen Schaltung als integrierter Schaltkreis (IC) ausgeführt ist.

8. Elektrische Schaltung nach Anspruch 7, **dadurch gekennzeichnet, dass** der integrierte Schaltkreis (IC) einen Anschluss (11) aufweist, an welchem die Einschaltspannung (Ue) angelegt werden kann.

9. Elektrische Schaltung nach Anspruch 7 oder 8, **dadurch gekennzeichnet, dass** der integrierte Schaltkreis (IC) zwei Anschlüsse (12, 13) aufweist, an welchen der Kondensator (C1) des Zeitglieds (R1, C1) angeschlossen werden kann.

10. Elektrische Schaltung nach einem der Ansprüche 7 bis 9, **dadurch gekennzeichnet, dass** der integrierte Schaltkreis (IC) zwei Anschlüsse (11, 12) aufweist, an welchen der erste ohmsche Widerstand (R1) des Zeitglieds (R1, C1) angeschlossen werden kann.

11. Elektrische Schaltung nach einem der Ansprüche 9 bis 10, **dadurch gekennzeichnet, dass** der integrierte Schaltkreis (IC) einen Anschluss (13) aufweist, an welchem der Verbraucher (V) angeschlossen werden kann.

12. Elektrische Schaltung nach einem der Ansprüche 7 bis 11, **dadurch gekennzeichnet, dass** der integrierte Schaltkreis (IC) als oberflächenmontierbares Bauelement (SMD) ausgestaltet ist.

## Claims

1. Electrical circuit for limiting the inrush current (I) through a load (V) during a switching-on processs, comprising
- an electrical component (T) which is connected in series with the load (V), said component (T) being designed as active component having an internal resistance (Ri) and comprising a transistor (T) having an input (D), an output (S) and a control terminal (G), said input (D) of the transistor (T) being connected to the load (V), and
- a timing element (R1, C1), which controls the component (T) in such a way that the internal resistance (Ri) of the component (T) is decreasing during the switching-on process, said timing element (R1, C1) comprising a capacitor (C1) and a first ohmic resistor (R1), via which the capacitor (C1) can be charged,
**characterised in that**
the output (S) of the transistor (T) is connected to earth (GND), a first terminal (2) of the capacitor (C1) is coupled to the input (D) of the transistor (T) and a second terminal (3) of the capacitor (C1) is coupled to a first terminal (4) of the first ohmic resistor (R1) and to a first terminal (6) of a second ohmic resistor (R2), and a second terminal (7) of the second ohmic resistor (R2) is coupled to the control terminal (G) of the transistor (T), and **in that** at least during the switching-on process a switching-on voltage (Ue), via which the capacitor (C1) can be charged, is present at a second terminal (5) of the first ohmic resistor (R1).

2. Electrical circuit according to claim 1, wherein the timing element (R1, C1) is configured in such a way that the internal resistance (Ri) of the component (T) is decreasing continuously, in particular exponentially, during the switching-on process.

3. Electrical circuit according to any of claims 1 or 2, wherein the timing element (R1, C1) exhibits a course over time which is independent of the load (V).

4. Electrical circuit according to claim 1, wherein the transistor (T) is configured as field effect transistor (FET), in particular as MOS field effect transistor (MOSFET).

5. Electrical circuit according to claim 1, wherein the control terminal (G) of the transistor (T) is coupled to a second terminal (5) of the first ohmic resistor (R1) via a diode (D1) and/or a third ohmic resistor (R3).

6. Electrical circuit according to claim 1, wherein the control terminal (G) of the transistor (T) is coupled to the output (S) of the transistor (T) via a diode (D1) and/or a fourth ohmic resistor (R4).

7. Electrical circuit according to any of the preceding claims, wherein at least part of the electrical circuit is implemented as integrated circuit (IC).

8. Electrical circuit according to claim 7, wherein the integrated circuit (IC) has a terminal (11), to which the switching-on voltage (Ue) can be applied.

9. Electrical circuit according to claim 7 or 8, wherein the integrated circuit (IC) has two terminals (12, 13), to which the capacitor (C1) of the timing element (R1, C1) can be connected.

10. Electrical circuit according to any of claims 7 to 9, wherein the integrated circuit (IC) has two terminals (11, 12), to which the first ohmic resistor (R1) of the timing element (R1, C1) can be connected.

11. Electrical circuit according to any of claims 9 to 10, wherein the integrated circuit (IC) has a terminal (13), to which the load (V) can be connected.

12. Electrical circuit according to any of claims 7 to 11, wherein the integrated circuit (IC) is configured as surface-mounted component (SMD).

## Revendications

1. Circuit électrique pour limiter le courant d'enclenchement (I) à travers un consommateur (V) pendant une opération d'enclenchement, comprenant :
- un composant électrique (T) qui est branché en série avec le consommateur (V), le composant (T) étant conçu comme un composant actif qui comporte une résistance interne (Ri) et comprenant un transistor (T) avec une entrée (D), une sortie (S) et une borne de commande (G), l'entrée (D) du transistor (T) étant reliée au consommateur (V), et
- un temporisateur (R1, C1) qui commande le composant (T) de telle sorte que la résistance interne (Ri) du composant (T) diminue pendant l'opération d'enclenchement, le temporisateur (R1, C1) comprenant un condensateur (C1) et une première résistance ohmique (R1) par l'intermédiaire de laquelle le condensateur (C1) peut être chargé,
**caractérisé par le fait que**
la sortie (S) du transistor (T) est à la masse (GND), qu'une première borne (2) du condensateur (C1) est reliée à l'entrée (D) du transistor (T) et une deuxième borne (3) du condensateur (C1) à une première borne (4) de la première résistance ohmique (R1) et à une première borne (6) d'une deuxième résistance ohmique (R2), et qu'une deuxième borne (7) de la deuxième résistance ohmique (R2) est reliée à la borne de commande (G) du transistor (T) et qu'il est appliqué à une deuxième borne (5) de la première résistance ohmique (R1), au moins pendant l'opération d'enclenchement, une tension d'enclenchement (Ue) par l'intermédiaire de laquelle le condensateur (C1) peut être chargé.

2. Circuit électrique selon la revendication 1, **caractérisé par le fait que** le temporisateur (R1, C1) est conçu de telle sorte que la résistance interne (Ri) du composant (T) diminue de façon continue, notamment exponentielle, pendant l'opération d'enclenchement.

3. Circuit électrique selon l'une des revendications 1 ou 2, **caractérisé par le fait que** le temporisateur (R1, C1) a un comportement temporel indépendant du consommateur (V).

4. Circuit électrique selon la revendication 1, **caractérisé par le fait que** le transistor (T) est conçu comme un transistor à effet de champ (FET), notamment comme un transistor à effet de champ MOS (MOSFET).

5. Circuit électrique selon la revendication 1, **caractérisé par le fait que** la borne de commande (G) du transistor (T) est reliée par l'intermédiaire d'une diode (D1) et/ou d'une troisième résistance ohmique (R3) à une deuxième borne (5) de la première résistance ohmique (R1).

6. Circuit électrique selon la revendication 1, **caractérisé par le fait que** la borne de commande (G) du transistor (T) est reliée par l'intermédiaire d'une diode (D1) et/ou d'une quatrième résistance ohmique (R4) à la sortie (S) du transistor (T).

7. Circuit électrique selon l'une des revendications précédentes, **caractérisé par le fait qu'**au moins une partie du circuit électrique est réalisée comme un circuit intégré (CI).

8. Circuit électrique selon la revendication 7, **caractérisé par le fait que** le circuit intégré (CI) comporte une borne (11) à laquelle la tension d'enclenchement (Ue) peut être appliquée.

9. Circuit électrique selon la revendication 7 ou 8, **caractérisé par le fait que** le circuit intégré (CI) comporte deux bornes (12, 13) auxquelles le condensateur (C1) du temporisateur (R1, C1) peut être raccordé.

10. Circuit électrique selon l'une des revendications 7 à 9, **caractérisé par le fait que** le circuit intégré (CI) comporte deux bornes (11, 12) auxquelles la première résistance ohmique (R1) du temporisateur (R1, C1) peut être raccordée.

11. Circuit électrique selon l'une des revendications 9 à 10, **caractérisé par le fait que** le circuit intégré (CI) comporte une borne (13) à laquelle le consommateur (V) peut être raccordé.

12. Circuit électrique selon l'une des revendications 7 à 11, **caractérisé par le fait que** le circuit intégré (CI) est conçu comme un composant monté en surface (SMD).
